# EUROPEAN PATENT SPECIFICATION

(11) **EP 3 869 386 B1**
(45) Date of publication and mention of the grant of the patent: **25.02.2026**
(21) Application number: 19872404.9
(22) Date of filing: 15.10.2019
(51) Int. Cl.: G06V 10/143, H10K 59/65, G06V 40/13

(54) **SCREEN ASSEMBLY, ELECTRONIC DEVICE AND CONTROL METHOD FOR SCREEN ASSEMBLY**
BILDSCHIRMANORDNUNG, ELEKTRONISCHE VORRICHTUNG UND VERFAHREN ZUR STEUERUNG DER BILDSCHIRMANORDNUNG
ENSEMBLE ÉCRAN, DISPOSITIF ÉLECTRONIQUE ET PROCÉDÉ DE COMMANDE D'ENSEMBLE ÉCRAN

(30) Priority: 16.10.2018 CN 201811202707
(43) Date of publication of application: 25.08.2021
(73) Proprietor: VIVO MOBILE COMMUNICATION CO., LTD., Dongguan, Guangdong 523860 (CN)
(72) Inventor: LIU, Chuan, Dongguan, Guangdong 523860 (CN)
(74) Representative: Winter, Brandl - Partnerschaft mbB
(86) International application number: PCT/CN2019/111220
(87) International publication number: WO 2020/078348

(56) References cited:
- CN-A- 101 285 952
- CN-A- 101 285 952
- CN-A- 101 819 340
- CN-A- 101 819 340
- CN-A- 101 957 693
- CN-A- 109 409 269
- US-A1- 2011 012 867
- US-A1- 2011 012 867
- US-A1- 2017 336 836

## Description

### TECHNICAL FIELD

This disclosure relates to the field of electronic technologies, and in particular, to a screen assembly, an electronic device, and a control method of a screen assembly.

### BACKGROUND

As users demand for aesthetic appearance and visual perception of high screen-to-body ratio terminals, full-screen mobile terminals have gradually become a development trend and are gradually going to the market. To improve overall screen-to-body ratios and aesthetics of mobile terminals, solutions such as in-screen fingerprint recognition and facial recognition have gradually emerged.

One of research and development ideas for in-screen fingerprint recognition in related art is to combine an organic light-emitting diode (Organic Light-Emitting Diode, OLED) screen to realize in-screen optical fingerprint recognition. This solution mainly uses an OLED emitting light source of the screen, and then performs fingerprint detection and recognition after emitted light is reflected by a finger to a sensor apparatus of a fingerprint module. However, because this solution uses OLED light to realize fingerprint recognition, its recognition rate is low, and it is difficult to emit light only to a fingerprint area, resulting in high power consumption. In addition, to increase a fingerprint recognition rate, it is necessary to increase light brightness of the OLED. As a result, power consumption is increased, and a user glares at strong light due to strong brightness of light, resulting in poor user experience. US 2017/336836 A1 (MÖRSKY TUOMO [FI] ET AL) 23 November 2017 (2017-11-23) is acknowledged.

In conclusion, in the related art, the solution of using an OLED screen to realize in-screen recognition has problems of a low recognition rate, high power consumption, and glare of strong light.

### SUMMARY

This disclosure provides a screen assembly, an electronic device, and a control method of a screen assembly, to resolve the problems of a low recognition rate, high power consumption, and glare of strong light in related art that uses OLED screen light to implement in-screen recognition.

The invention is set out in the appended set of claims.

In the embodiments of this disclosure, the infrared light source module arranged at the display panel provides infrared light to the infrared photosensitive module arranged under the display panel for the infrared photosensitive module to realize photosensitive detection. In this way, the purpose of in-screen recognition and detection by the infrared photosensitive module can be achieved, the problems of high power consumption and glare of strong light due to direct emission of the display panel in related art can be avoided, thus reducing power consumption and increasing a detection and recognition rate of the infrared photosensitive module.

### BRIEF DESCRIPTION OF DRAWINGS

To describe the technical solutions in the embodiments of this disclosure more clearly, the following briefly describes the accompanying drawings required for describing the embodiments of this disclosure. Apparently, the accompanying drawings in the following description show merely some embodiments of this disclosure, and a person of ordinary skill in the art may derive other drawings from these accompanying drawings without creative efforts.
FIG. 1 is a first schematic structural diagram of a screen assembly according to an embodiment of this disclosure;
FIG. 2 is a second schematic structural diagram of a screen assembly according to an embodiment of this disclosure;
FIG. 3 is a third schematic structural diagram of a screen assembly according to an embodiment of this disclosure;
FIG. 4 is a schematic cross-sectional view of the screen assembly shown in FIG. 3;
FIG. 5 is a fourth schematic structural diagram of a screen assembly according to an embodiment of this disclosure;
FIG. 6 is an diagram illustrating a scenario in which one emission light source is used for both in-screen fingerprint recognition and facial recognition in a screen assembly according to an embodiment of this disclosure; and
FIG. 7 is a schematic flowchart of a control method of a screen assembly according to an embodiment of this disclosure.

### DESCRIPTION OF EMBODIMENTS

To make the to-be-resolved technical problems, technical solutions, and advantages of this disclosure clearer, the following provides detailed descriptions with reference to the accompanying drawings and specific embodiments.

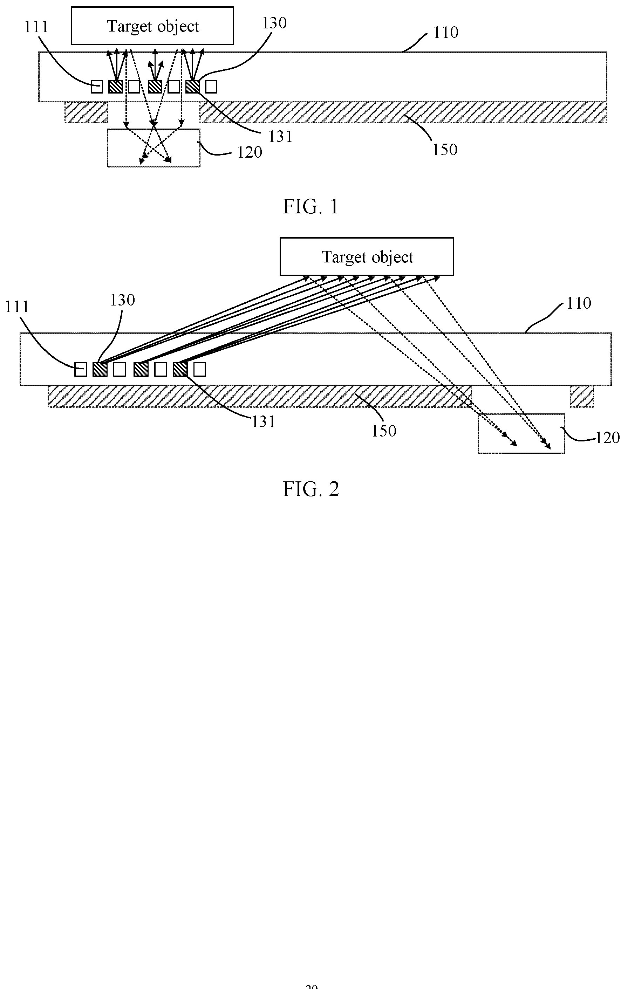

Referring to FIG. 1 and FIG. 2, an embodiment of this disclosure provides a screen assembly, which may include:
a display panel 110;
an infrared light source module 130, where the infrared light source module 130 is arranged at the display panel 110, and the infrared light source module 130 is configured to emit infrared light to one side of the display panel 110; and
an infrared photosensitive module 120, where the infrared photosensitive module 120 is arranged on the other side of the display panel 110, and the infrared photosensitive module is configured to receive reflected light formed after the infrared light emitted by the infrared light source module 130 irradiates on a target object and is reflected to the infrared photosensitive module 120.

In this embodiment of this disclosure, the infrared light source module 130 is arranged at the display panel 110 to provide infrared light to the infrared photosensitive module 120 arranged under the display panel 110 for the infrared photosensitive module to realize photosensitive detection. In this way, the purpose of in-screen recognition and detection by the infrared photosensitive module 120 can be achieved. In addition, using the infrared light source module 130 to provide infrared light can avoid the problems of high power consumption and glare of strong light due to direct full-screen emission of the display panel 110 in related art, thus reducing power consumption and increasing a detection and recognition rate of the infrared photosensitive module 120.

In this embodiment of this disclosure, the display panel 110 may be an OLED display panel. A basic structure of the display panel 110 is a sandwich-like structure formed by a thin, transparent, semiconductor-like indium tin oxide (ITO) connected to a positive electrode of a power source, and a metal cathode. This structure enables the infrared light source module 130 to be built in the display panel 110. Therefore, according to this invention, the infrared light source module 130 is arranged inside the display panel 110, thus enabling a compact structure, which is beneficial to reduce thickness of the screen assembly, making it light and thin.

Specifically, as shown in FIG. 1 and FIG. 2, the screen assembly starts the infrared light source module 130 and the infrared photosensitive module 120, to emit infrared light by using the infrared light source module 130. The infrared light emitted by the infrared light source module (the emitted infrared light is indicated by solid lines with arrows in FIG. 1 and FIG. 2) is projected to a target object to form reflected light (the reflected light may include emitted light and scattered light, as indicated by dotted lines with arrows in FIG. 1 and FIG. 2), and reflected to the infrared photosensitive module 120. The infrared photosensitive module 120 receives the reflected light and generates detection information based on the reflected light.

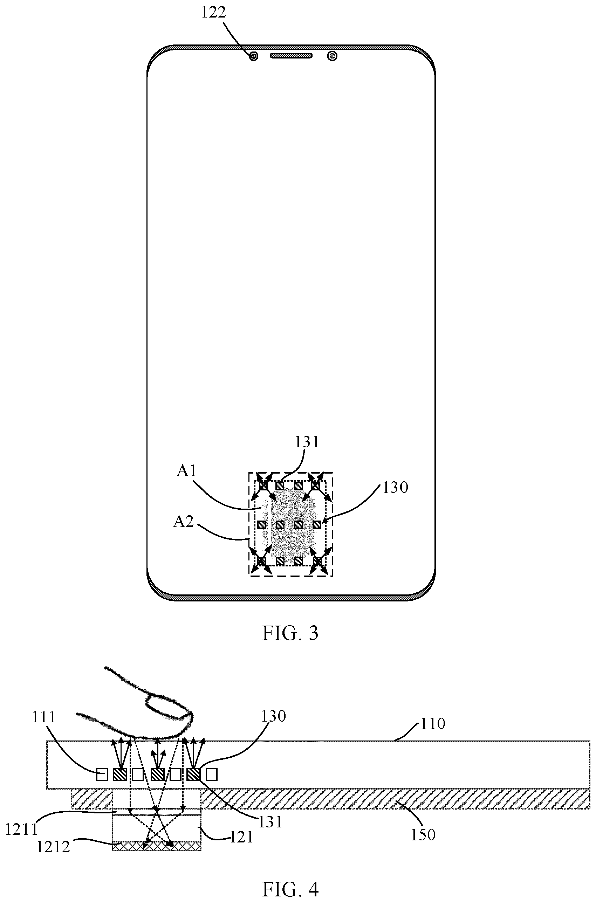

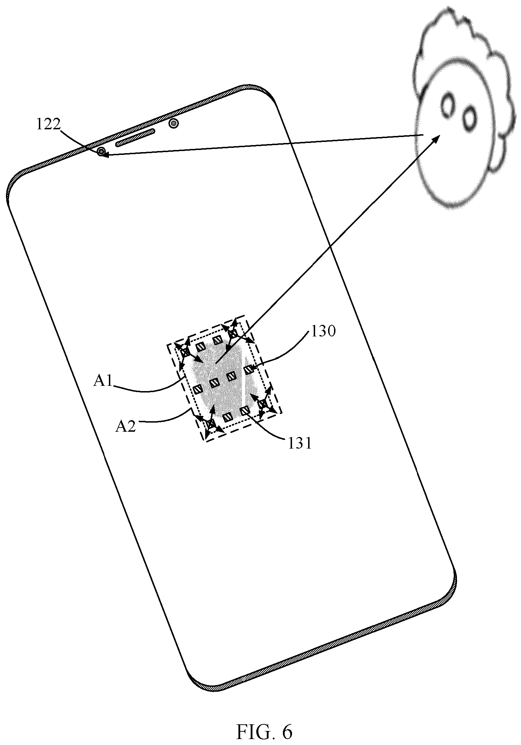

As shown in FIG. 4, the target object may be a finger, or, as shown in FIG. 6, the target object may be a human face, or the target object may be a photographed object, including scenes or other objects. Specific identification of the target object may be set based on a specific type or specific purpose of the infrared photosensitive module 120. Optionally, in this embodiment of this disclosure, the infrared photosensitive module 120 may be at least one of a fingerprint recognition module 121, a facial recognition module, and an infrared camera module 122.

In an optional embodiment of this disclosure, the infrared photosensitive module 120 includes the fingerprint recognition module 121, and the fingerprint recognition module 121 corresponds to an arrangement position of the infrared light source module 130, where an irradiation area of the infrared light emitted by the infrared light source module 130 on the display panel 110 covers a fingerprint recognition area of the fingerprint recognition module 121. As shown in FIG. 3, FIG. 5, and FIG. 6, a block area designated A1 represents the fingerprint recognition area of the fingerprint recognition module 121, and a block area designated A2 represents the irradiation area of the infrared light emitted by the infrared light source module 130 on the display panel 110. In specific application, the fingerprint recognition area of the fingerprint recognition module 121 and the irradiation area of the infrared light emitted by the infrared light source module 130 on the display panel 110 may be set to various shapes, such as a circle, an ellipse, a heart shape, or a star shape, and may be specifically set according to an actual structure design, an effect requirement, or the like.

In this embodiment of this disclosure, the infrared light source module 130 may be built in the display panel 110, and the arrangement position of the infrared light source module 130 corresponds to the fingerprint recognition module 121, so that the infrared light source module 130 can provide infrared light for the fingerprint recognition module 121 for fingerprint recognition. In this way, the purpose of in-screen fingerprint recognition of the screen assembly can be achieved, and the infrared light source module 130 is configured to provide infrared light for the fingerprint recognition module 121. This can increase a fingerprint recognition rate and reduce power consumption, while avoiding the problem of glare of strong light in fingerprint recognition in related art.

Specifically, as shown in FIG. 4, when a finger touch is detected in the fingerprint recognition area, the screen assembly starts the infrared light source module 130 and the fingerprint recognition module 121, to emit infrared light through the infrared light source module 130. The infrared light emitted by the infrared light source module (the emitted infrared light is indicated by solid lines with arrows in FIG. 4) is projected to a target object to form reflected light (the reflected light may include emitted light and scattered light, as indicated by dotted lines with arrows in FIG. 4), and reflected to the fingerprint recognition module 121. The fingerprint recognition module 121 receives the reflected light and generates detection information based on the reflected light, and transmits the detection information to a processor for fingerprint recognition.

In an optional embodiment of this disclosure, as shown in FIG. 4, the fingerprint recognition module 121 may include an infrared fingerprint sensor 1211, to receive and process, through the infrared fingerprint sensor 1211, the emitted light projected by the infrared light source module 130 on the finger and then reflected by the finger, to realize fingerprint recognition. In addition, the fingerprint recognition module 121 may further include a lens 1212. The infrared light emitted by the infrared light source module 130 is projected on the finger and then reflected to form reflected light. The reflected light includes reflected rays or scattered rays, which pass through the lens 1212 and are refracted to the infrared fingerprint sensor 1211 according to the lens imaging principle, for receiving and processing by the infrared fingerprint sensor 1211.

As shown in FIG. 3, FIG. 5, and FIG. 6, in an optional embodiment of this disclosure, the infrared photosensitive module 120 includes an infrared camera module 122, configured to receive the reflected light formed by the emitted light irradiated by the infrared light source module 130 on the target object (photographed object) and process imaging. In this embodiment of this disclosure, the infrared camera module 122 can cooperate with the infrared light source module 130 to take photographs so as to realize infrared photography. In addition, in some embodiments, the infrared camera module 122 may be configured to realize a facial recognition function. Optionally, the infrared camera module 122 includes an infrared camera.

In some optional embodiments of this disclosure, the infrared photosensitive module 120 may include at least two of the fingerprint recognition module 121, the facial recognition module, and the infrared camera module 122. In this way, a plurality of types of infrared photosensitive modules 120 can use one emission light source.

As shown in FIG. 6, the infrared photosensitive module 120 includes both the fingerprint recognition module 121 and the infrared camera module 122, so that one emission light source is used for in-screen fingerprint recognition of the screen assembly and the infrared photography, thereby canceling an original infrared emitting component configured for infrared photography, saving device arrangement space, and reducing manufacturing costs.

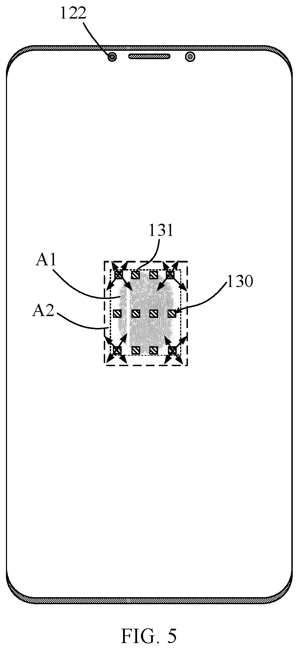

Advantageously, as shown in FIG. 5, in this embodiment of this disclosure, a distance between the fingerprint recognition module 121 and the infrared camera module 122 is less than a preset value. The preset value may be specifically set based on setting requirements such as an emission angle and an emission distance of the emitted light of the infrared light source module 130. Herein, the setting of the preset value needs to at least ensure that the infrared light emitted by the infrared light source module 130 can irradiate an object within a predetermined range and the infrared camera module 122 can receive the emitted light formed by the infrared light irradiating on the photographed object. As shown in FIG. 5, in an example, the preset value may be 1/2 of a length of the screen assembly in a length direction. In this way, the fingerprint recognition area of the fingerprint recognition module 121 can be located in the middle of the screen assembly, thereby ensuring that the infrared camera module 122 cooperates with the infrared light source module 130 to implement photography, and facilitating recognition of user fingerprints, making it easier for the user to touch the fingerprint recognition area especially in the case of a large-sized screen assembly.

According to this invention, as shown in FIG. 4, the infrared light source module 130 includes a plurality of infrared light emitting diodes 131, and the plurality of infrared light emitting diodes 131 are spaced apart from LED light emitting components of the display panel 110. In this embodiment of this disclosure, the plurality of infrared light emitting diodes 131 being spaced apart from the LED light emitting components can ensure that the infrared light emitting diodes 131 and the LED light emitting components do not affect each other. The function of the infrared photosensitive module 120 of the screen assembly can be ensured without affecting normal imaging of the display panel 110.

Optionally, in this embodiment of this disclosure, the plurality of infrared light emitting diodes 131 are spaced apart from pixel units 111 of the display panel 110, which facilitates a reasonable layout and can reduce space costs.

In this embodiment of this disclosure, the plurality of infrared light emitting diodes 131 in the display panel 110 may be specifically arranged according to an actual structure design, an infrared light emission effect, and the like. Optionally, in this embodiment of this disclosure, as shown in FIG. 3 and FIG. 5, the plurality of infrared light emitting diodes 131 are equidistantly arranged in a plurality of rows; or, the plurality of infrared light emitting diodes 131 are arranged into a matrix.

In addition, in this embodiment of this disclosure, a quantity and position arrangement of the plurality of infrared light emitting diodes 131 may alternatively be designed according to an implementation effect.

It can be understood that, in this embodiment of this disclosure, to increase receiving intensity of the infrared photosensitive module or to adapt to receiving intensity of different types of infrared photosensitive modules, it is only necessary to adjust emission intensity of the infrared light emitted by the infrared light source module 130, which can effectively avoid glare of strong light in related art, reduce power consumption, and prolong battery life.

According to this invention, the infrared light source module 130 has a drive component connected to the plurality of infrared light emitting diodes 131, configured to start the plurality of infrared light emitting diodes 131 and adjust the emission intensity of the plurality of infrared light emitting diodes 131. The plurality of infrared light emitting diodes 131 can be better controlled by the drive component, and the plurality of infrared light emitting diodes 131 are adjusted to emission intensity that suits actual needs, so as to meet various usage requirements of users.

It should be noted that the infrared light source module 130 is set with emission intensity suiting different types of infrared photosensitive modules 120. To be specific, when the infrared photosensitive module 120 to be invoked is the fingerprint recognition module 121, the facial recognition module, or the infrared camera module 122, the drive component adjusts the emission intensity of the plurality of infrared light emitting diodes 131 to a suitable emission intensity value.

For example, if the infrared photosensitive module 120 includes the fingerprint recognition module 121, when the fingerprint recognition module 121 is invoked, the drive component adjusts the emission intensity of the plurality of infrared light emitting diodes 131 to a first preset intensity value; if the infrared photosensitive module 120 includes the facial recognition module, when the facial recognition module is invoked, the drive component adjusts the emission intensity of the plurality of infrared light emitting diodes 131 to a second preset intensity value; and if the infrared photosensitive module 120 includes the infrared camera module 122, when the infrared camera module 122 is invoked, the drive component adjusts the emission intensity of the plurality of infrared light-emitting diodes 131 to a third preset intensity value, where the first preset intensity value is less than the second preset intensity value, and the third preset intensity value is greater than or equal to the second preset intensity value.

In addition, in an embodiment of this disclosure, as shown in FIG. 1, an orthographic projection of at least a portion of the infrared photosensitive module 120 on the display panel 110 is within the range of an orthographic projection of the infrared light source module 130 on the display panel 110. For example, in an example, the infrared photosensitive module 120 includes the fingerprint recognition module 121. As shown in FIG. 4, an orthographic projection of the fingerprint recognition module 121 on the display panel 110 may be entirely or partially located within the range of an orthographic projection of the infrared light source module 130 on the display panel 110.

In another embodiment of this disclosure, as shown in FIG. 2, the orthographic projection of the infrared photosensitive module 120 on the display panel 110 is spaced apart from the orthographic projection of the infrared light source module 130 on the display panel 110. For example, in an example, the infrared photosensitive module 120 includes the infrared camera module 122, as shown in FIG. 3, FIG. 5, and FIG. 6, an orthographic projection of the infrared camera module 122 on the display panel 110 is spaced apart from an orthographic projection of the infrared light source module 130 on the display panel 110, where a spacing between the two may be set according to actual design requirements.

Referring to FIG. 1, FIG. 2, and FIG. 4, in an embodiment of this disclosure, the screen assembly may further include: a middle frame structure 150, which is attached to the display panel 110 and is arranged on the other side of the display panel 110 opposite an infrared light emitting direction of the infrared light source module 130. In this embodiment of this disclosure, the middle frame structure 150 is attached to the display panel 110 to support the display panel 110.

Optionally, in this embodiment of this disclosure, to ensure that the light reception of the infrared photosensitive module 120 is not affected, the middle frame structure 150 is provided with an opening corresponding to the infrared photosensitive module 120. It should be noted that the size of the opening should meet a preset requirement to at least ensure that the infrared photosensitive module 120 can receive the reflected or scattered reflected light in a predetermined area (for example, the fingerprint recognition area of the fingerprint recognition module 121).

In the screen assembly provided in this embodiment of this disclosure, the infrared light source module arranged at the display panel provides infrared light to the infrared photosensitive module arranged under the display panel for the infrared photosensitive module to realize photosensitive detection. In this way, the purpose of in-screen recognition and detection by the infrared photosensitive module can be achieved, and the problems of high power consumption and glare of strong light due to direct emission of the display panel in related art can be avoided, thus reducing power consumption and increasing a detection and recognition rate of the infrared photosensitive module.

In addition, an embodiment of this disclosure provides an electronic device, including the foregoing screen assembly.

The electronic device may further include a series of basic components such as a receiver, a speaker, a microphone, and a housing for accommodating various components, which are not further described in this embodiment of this disclosure.

In addition, in this embodiment of this disclosure, the electronic device may be a mobile phone or a tablet computer. Certainly, the electronic device is not limited to a mobile phone or a tablet computer, but may be a terminal device such as a laptop computer (Laptop Computer) or a personal digital assistant (Personal Digital Assistant, PDA).

In this embodiment of this disclosure, for the electronic device with the above-mentioned screen assembly, as the screen assembly can achieve the purpose of in-screen recognition and detection by the infrared photosensitive module, the problems of high power consumption and glare of strong light due to direct emission of the display panel in related art can be avoided, thus reducing power consumption and increasing a detection and recognition rate of the infrared photosensitive module. This allows the electronic device to implement an in-screen recognition function with an increased recognition rate and reduced power consumption, while avoiding the problem of glare of strong light in related art.

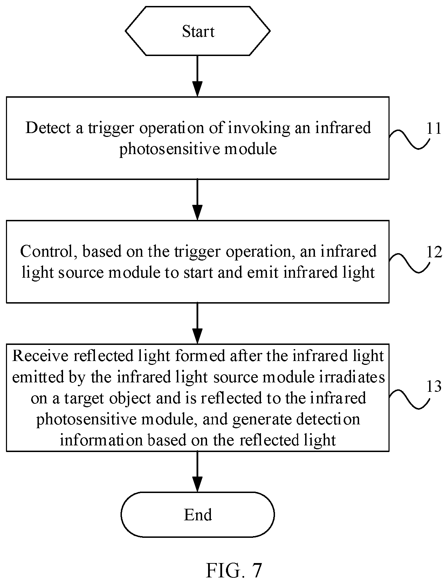

In addition, FIG. 7 is a schematic flowchart of a control method of a screen assembly according to an embodiment of this disclosure. This embodiment of this disclosure also provides a control method of a screen assembly, applied to the foregoing screen assembly. The control method of a screen assembly may include the following steps:
Step 11: Detect a trigger operation of invoking an infrared photosensitive module.
Step 12: Control, based on the trigger operation, an infrared light source module to start and emit infrared light.
Step 13: Receive reflected light formed after the infrared light emitted by the infrared light source module irradiates on a target object and is reflected to an infrared photosensitive module, and generate detection information based on the reflected light.

In this embodiment of this disclosure, after it is detected that a user triggers the infrared photosensitive module, the infrared light source module arranged at the display panel is controlled to start and emit infrared light, so that the infrared light is projected to the target object to form reflected light; and then the reflected light is received through the infrared photosensitive module, and detection information is generated based on the reflected light. In this way, the purpose of in-screen recognition and detection by the infrared photosensitive module can be achieved, and the problems of high power consumption and glare of strong light due to direct emission of the display panel in related art can be avoided, thus reducing power consumption and increasing a detection and recognition rate of the infrared photosensitive module.

In this embodiment of this disclosure, to better control and adjust the infrared light source module, the infrared light source module has a drive component, and the drive component is connected to a plurality of infrared light emitting diodes. In an optional embodiment of this disclosure, in step 12, the controlling, based on the trigger operation, the infrared light source module to start may include: sending a control instruction to the drive component of the infrared light source module based on the trigger operation, and by the driving component, starting the plurality of infrared light emitting diodes of the infrared light source module and adjusting emission intensity of the plurality of infrared light-emitting diodes.

Specifically, the infrared light source module can set emission intensity suiting different types of infrared photosensitive modules. To be specific, when the infrared photosensitive module to be invoked is a fingerprint recognition module, a facial recognition module, or an infrared camera module, the drive component may adjust the emission intensity of the plurality of infrared light emitting diodes to a suitable emission intensity value. In this embodiment of this disclosure, the sending a control instruction to the drive component of the infrared light source module based on the trigger operation, and by the drive component, starting the plurality of infrared light-emitting diodes of the infrared light source module and adjusting emission intensity of the plurality of infrared light emitting diodes may include: when the fingerprint recognition module is invoked, sending a first control instruction to the drive component of the infrared light source module based on the trigger operation, and by the drive component, starting the plurality of infrared light emitting diodes of the infrared light source module and adjusting the emission intensity of the plurality of infrared light emitting diodes to a first preset intensity value; when the facial recognition module is invoked, sending a second control instruction to the drive component of the infrared light source module based on the trigger operation, and by the drive component, starting the plurality of infrared light emitting diodes of the infrared light source module and adjusting the emission intensity of the plurality of infrared light emitting diodes to a second preset intensity value; and when the infrared camera module is invoked, sending a third control instruction to the drive component of the infrared light source module based on the trigger operation, and by the drive component, starting the plurality of infrared light emitting diodes of the infrared light source module and adjusting the emission intensity of the plurality of infrared light-emitting diodes to a third preset intensity value.

In the control method of a screen assembly provided in this embodiment of this disclosure, the purpose of in-screen recognition and detection by the infrared photosensitive module can be achieved, and the problems of high power consumption and glare of strong light due to direct emission of the display panel in related art can be avoided, thus reducing power consumption and increasing a detection and recognition rate of the infrared photosensitive module.

It should be understood that references to terms "an embodiment", "one embodiment", and "some embodiments" in the specification mean that specified features, structures, or characteristics related to the embodiment are included in at least one embodiment or example of this disclosure. Therefore, "in an embodiment", "in one embodiment", or "in some embodiments" appearing throughout the specification does not necessarily refer to a same embodiment. In addition, the elements, structures, or features described in an accompanying drawing or an embodiment of this disclosure may be combined with elements, structures, or features shown in one or more other accompanying drawings or embodiments in any suitable manner.

It should be noted that in one of more embodiments of this specification, the term "comprise", "include", or any other variant thereof is intended to cover a non-exclusive inclusion, so that a process, a method, an article, or an apparatus that includes a list of elements not only includes those elements but also includes other elements that are not expressly listed, or further includes elements inherent to such process, method, article, or apparatus. In absence of more constraints, an element preceded by "includes a..." does not preclude the existence of other identical elements in the process, method, article, or apparatus that includes the element.

In this disclosure, unless otherwise specified and defined explicitly, the terms "mounted", "interconnected", "connected", "fastened", and "arranged" are to be interpreted broadly, for example, may be fixedly connected, or detachably connected, or integrated, may be mechanically connected or electrically connected, and may be directly connected or indirectly connected through an intermediate medium, or internally communicated between two elements or interacted between two elements. A person of ordinary skill in the art can understand specific meanings of these terms in this disclosure based on specific situations.

In addition, this disclosure may repeat reference numerals and/or letters in different embodiments or examples. This repetition is for the purpose of simplification and clarity, and does not in itself indicate any relationship between the various embodiments and/or arrangements discussed.

Moreover, in the embodiments of this disclosure, relational terms such as first and second are used only to differentiate one entity or operation from another entity or operation, and do not necessarily require or imply that any actual relationship or sequence exist between these entities or operations.

The embodiments of this disclosure are described above with reference to the accompanying drawings, but this disclosure is not limited to the foregoing implementations. The foregoing implementations are only illustrative rather than restrictive. Inspired by this disclosure, a person of ordinary skill in the art can still derive many variations without departing from the protection scope of the claims. All these variations shall fall within the protection of this disclosure.

## Claims

1. A screen assembly, **characterized by** comprising:
a display panel (110);
an infrared light source module (130), wherein the infrared light source module (130) is arranged at the display panel (110) and faces toward one side of the display panel (110), and the infrared light source module (130) is configured to emit infrared light to the one side of the display panel (110); and
an infrared photosensitive module (120), wherein the infrared photosensitive module (120) is arranged on the other side of the display panel (110), and the infrared photosensitive module (120) is configured to receive reflected light formed after the infrared light emitted by the infrared light source module (130) irradiates on a target object and is reflected to the infrared photosensitive module (120);
wherein the infrared photosensitive module (120) comprises at least two of a fingerprint recognition module (121), a facial recognition module, and an infrared camera module (122);
wherein the infrared light source module (130) is arranged inside the display panel (110);
wherein the infrared light source module (130) comprises:
a plurality of infrared light emitting diodes (131), wherein the plurality of infrared light emitting diodes (131) are spaced apart from LED light emitting components of the display panel (110);
wherein the infrared light source module (130) has a drive component, wherein the drive component is connected to the plurality of infrared light emitting diodes (131) and is configured to start the plurality of infrared light emitting diodes (131) and adjust emission intensity of the plurality of infrared light emitting diodes (131) to a preset emission intensity value that suits one of the at least two of the fingerprint recognition module (121), the facial recognition module, and the infrared camera module (122) when the one of the at least two of the fingerprint recognition module (121), the facial recognition module, and the infrared camera module (122) is invoked.

2. The screen assembly according to claim 1, wherein the plurality of infrared light emitting diodes (131) are spaced apart from pixel units (111) of the display panel (110).

3. The screen assembly according to claim 1, wherein the plurality of infrared light emitting diodes (131) are spaced apart in a plurality of rows.

4. The screen assembly according to claim 1, wherein the plurality of infrared light emitting diodes (131) are arranged into a matrix.

5. The screen assembly according to claim 1, wherein an orthographic projection of at least a portion of the infrared photosensitive module (120) on the display panel (110) is within the range of an orthographic projection of the infrared light source module (130) on the display panel (110).

6. The screen assembly according to claim 1, wherein an orthographic projection of the infrared photosensitive module (120) on the display panel (110) is spaced apart from an orthographic projection of the infrared light source module (130) on the display panel (110).

7. An electronic device, **characterized by** comprising the screen assembly according to any one of claims 1 to 6.

8. A control method of a screen assembly, **characterized in that**, the method is applied to the screen assembly according to any one of claims 1 to 6, and comprises:
detecting (11) a trigger operation of invoking an infrared photosensitive module (120);
controlling (12), based on the trigger operation, an infrared light source module (130) to start and emit infrared light; and
receiving (13), by the infrared photosensitive module (120), reflected light formed after the infrared light emitted by the infrared light source module (130) irradiates on a target object and is reflected to the infrared photosensitive module (120), and generating detection information based on the reflected light.

9. The control method according to claim 8, wherein the controlling, based on the trigger operation, the infrared light source module (130) to start comprises:
sending a control instruction to a drive component of the infrared light source module (130) based on the trigger operation, and by the drive component, starting a plurality of infrared light emitting diodes (131) of the infrared light source module (130) and adjusting emission intensity of the plurality of infrared light-emitting diodes.

## Patentansprüche

1. Bildschirmanordnung, **gekennzeichnet durch**
ein Anzeigefeld (110);
ein Infrarotlichtquellenmodul (130), wobei das Infrarotlichtquellenmodul (130) an dem Anzeigefeld (110) angeordnet ist und einer Seite des Anzeigefelds (110) zugewandt ist, und das Infrarotlichtquellenmodul (130) dazu ausgelegt ist, Infrarotlicht zu der einen Seite des Anzeigefelds (110) zu emittieren; und
ein Infrarotlichtempfindliches Modul (120), wobei das Infrarotlichtempfindliche Modul (120) auf der anderen Seite des Anzeigefelds (110) angeordnet ist, und das Infrarotlichtempfindliche Modul (120) dazu ausgelegt ist, reflektiertes Licht zu empfangen, das gebildet wird, nachdem das von dem Infrarotlichtquellenmodul (130) emittierte Infrarotlicht auf ein Zielobjekt strahlt und zu dem Infrarotlichtempfindlichen Modul (120) reflektiert wird;
wobei das Infrarotlichtempfindliche Modul (120) mindestens zwei von einem Fingerabdruckerkennungsmodul (121), einem Gesichtserkennungsmodul und einem Infrarotkameramodul (122) aufweist;
wobei das Infrarotlichtquellenmodul (130) innerhalb des Anzeigefelds (110) angeordnet ist;
wobei das Infrarotlichtquellenmodul (130)
eine Mehrzahl von Infrarotlicht emittierenden Dioden (131) aufweist, wobei die Mehrzahl von Infrarotlicht emittierenden Dioden (131) von LED-Licht emittierenden Komponenten des Anzeigefelds (110) beabstandet sind;
wobei das Infrarotlichtquellenmodul (130) eine Ansteuerungskomponente aufweist, wobei die Ansteuerungskomponente mit der Mehrzahl von Infrarotlicht emittierenden Dioden (131) verbunden ist und dazu ausgelegt ist, die Mehrzahl von Infrarotlicht emittierenden Dioden (131) zu starten und die Emissionsintensität der Mehrzahl von Infrarotlicht emittierenden Dioden (131) auf einen voreingestellten Emissionsintensitätswert einzustellen, der für eines der mindestens zwei von dem Fingerabdruckerkennungsmodul (121), dem Gesichtserkennungsmodul und dem Infrarotkameramodul (122) geeignet ist, wenn das eine der mindestens zwei von dem Fingerabdruckerkennungsmodul (121), dem Gesichtserkennungsmodul und dem Infrarotkameramodul (122) aufgerufen wird.

2. Bildschirmanordnung nach Anspruch 1, wobei die Mehrzahl von Infrarotlicht emittierenden Dioden (131) von Pixeleinheiten (111) des Anzeigefelds (110) beabstandet sind.

3. Bildschirmanordnung nach Anspruch 1, wobei die Mehrzahl von Infrarotlicht emittierenden Dioden (131) in einer Mehrzahl von Reihen beabstandet sind.

4. Bildschirmanordnung nach Anspruch 1, wobei die Mehrzahl von Infrarotlicht emittierenden Dioden (131) in einer Matrix angeordnet sind.

5. Bildschirmanordnung nach Anspruch 1, wobei eine orthografische Projektion von mindestens einem Abschnitt des Infrarotlichtempfindlichen Moduls (120) auf das Anzeigefeld (110) innerhalb des Bereichs einer orthografischen Projektion des Infrarotlichtquellenmoduls (130) auf das Anzeigefeld (110) liegt.

6. Bildschirmanordnung nach Anspruch 1, wobei eine orthografische Projektion des Infrarotlichtempfindlichen Moduls (120) auf das Anzeigefeld (110) von einer orthografischen Projektion des Infrarotlichtquellenmoduls (130) auf das Anzeigefeld (110) beabstandet ist.

7. Elektronische Vorrichtung, **dadurch gekennzeichnet, dass** sie die Bildschirmanordnung nach einem der Ansprüche 1 bis 6 aufweist.

8. Verfahren zur Steuerung einer Bildschirmanordnung, **dadurch gekennzeichnet, dass** das Verfahren auf die Bildschirmanordnung nach einem der Ansprüche 1 bis 6 angewendet wird und die folgenden Schritte umfasst:
Erfassen (11) eines Auslösevorgangs zum Aufrufen eines infrarotlichtempfindlichen Moduls (120);
Steuern (12), basierend auf dem Auslösevorgang, eines Infrarotlichtquellenmoduls (130), um dieses zu starten und Infrarotlicht zu emittieren; und
Empfangen (13), durch das Infrarotlichtempfindliche Modul (120), von reflektiertem Licht, das gebildet wird, nachdem das von dem Infrarotlichtquellenmodul (130) emittierte Infrarotlicht auf ein Zielobjekt strahlt und zu dem Infrarotlichtempfindlichen Modul (120) reflektiert wird, und Erzeugen von Erfassungsinformationen basierend auf dem reflektierten Licht.

9. Verfahren zur Steuerung einer Bildschirmanordnung nach Anspruch 8, wobei das Ansteuern, basierend auf dem Auslösevorgang, des Infrarotlichtquellenmoduls (130) zum Starten umfasst:
Senden eines Steuerbefehls an eine Ansteuerungskomponente des Infrarotlichtquellenmoduls (130) basierend auf dem Auslösevorgang, und durch die Ansteuerungskomponente, Starten einer Mehrzahl von Infrarotlicht emittierenden Dioden (131) des Infrarotlichtquellenmoduls (130) und Anpassen der Emissionsintensität der Mehrzahl von Infrarotlicht emittierenden Dioden.

## Revendications

1. Ensemble écran, **caractérisé en ce qu'**il comprend :
un panneau d'affichage (110) ;
un module de source de lumière infrarouge (130), dans lequel le module de source de lumière infrarouge (130) est agencé au niveau du panneau d'affichage (110) et orienté vers un côté du panneau d'affichage (110), et le module de source de lumière infrarouge (130) est configuré pour émettre de la lumière infrarouge vers ce côté du panneau d'affichage (110) ; et
un module photosensible infrarouge (120), dans lequel le module photosensible infrarouge (120) est agencé de l'autre côté du panneau d'affichage (110), et le module photosensible infrarouge (120) est configuré pour recevoir une lumière réfléchie formée après que la lumière infrarouge émise par le module de source de lumière infrarouge (130) irradie un objet cible et est réfléchie vers le module photosensible infrarouge (120) ;
dans lequel le module photosensible infrarouge (120) comprend au moins deux modules parmi un module de reconnaissance d'empreintes digitales (121), un module de reconnaissance faciale et un module de caméra infrarouge (122) ;
dans lequel le module de source de lumière infrarouge (130) est agencé à l'intérieur du panneau d'affichage (HO) ;
dans lequel le module de source de lumière infrarouge (130) comprend :
une pluralité de diodes électroluminescentes infrarouges (131), dans lequel la pluralité de diodes électroluminescentes infrarouges (131) sont espacées des composants électroluminescents LED du panneau d'affichage (110) ;
dans lequel le module de source de lumière infrarouge (130) comporte un composant d'entraînement, dans lequel le composant d'entraînement est relié à la pluralité de diodes électroluminescentes infrarouges (131) et est configuré pour démarrer la pluralité de diodes électroluminescentes infrarouges (131) et ajuster l'intensité d'émission de la pluralité de diodes électroluminescentes infrarouges (131) à une valeur d'intensité d'émission prédéfinie qui convient à l'un des au moins deux modules parmi le module de reconnaissance d'empreintes digitales (121), le module de reconnaissance faciale et le module de caméra infrarouge (122), lorsque l'un des au moins deux modules parmi le module de reconnaissance d'empreintes digitales (121), le module de reconnaissance faciale et le module de caméra infrarouge (122) est activé.

2. Ensemble écran selon la revendication 1, dans lequel la pluralité de diodes électroluminescentes infrarouges (131) sont espacées d'unités de pixels (111) du panneau d'affichage (110).

3. Ensemble écran selon la revendication 1, dans lequel la pluralité de diodes électroluminescentes infrarouges (131) sont espacées dans une pluralité de rangées.

4. Ensemble écran selon la revendication 1, dans lequel la pluralité de diodes électroluminescentes infrarouges (131) sont agencées dans une matrice.

5. Ensemble écran selon la revendication 1, dans lequel une projection orthographique d'au moins une partie du module photosensible infrarouge (120) sur le panneau d'affichage (110) est à portée d'une projection orthographique du module de source de lumière infrarouge (130) sur le panneau d'affichage (110).

6. Ensemble écran selon la revendication 1, dans lequel une projection orthographique du module photosensible infrarouge (120) sur le panneau d'affichage (110) est espacée d'une projection orthographique du module de source de lumière infrarouge (130) sur le panneau d'affichage (110).

7. Dispositif électronique, **caractérisé en ce qu'**il comprend l'ensemble écran selon l'une quelconque des revendications 1 à 6.

8. Procédé de commande d'un ensemble écran, **caractérisé en ce que** le procédé est appliqué à l'ensemble écran selon l'une quelconque des revendications 1 à 6, et comprend :
la détection (11) d'une opération de déclenchement d'invocation d'un module photosensible infrarouge (120) ;
la commande (12), sur la base de l'opération de déclenchement, d'un module de source de lumière infrarouge (130) pour démarrer et émettre une lumière infrarouge ; et
la réception (13), par le module photosensible infrarouge (120), de la lumière réfléchie formée après que la lumière infrarouge émise par le module de source de lumière infrarouge (130) irradie un objet cible et est réfléchie vers le module photosensible infrarouge (120), et la génération d'informations de détection sur la base de la lumière réfléchie.

9. Procédé de commande selon la revendication 8, dans lequel la commande, sur la base de l'opération de déclenchement, du module de source de lumière infrarouge (130) pour démarrer comprend :
l'envoi d'une instruction de commande à un composant d'entraînement du module de source de lumière infrarouge (130) sur la base de l'opération de déclenchement et, par le composant d'entraînement, le démarrage d'une pluralité de diodes électroluminescentes infrarouges (131) du module de source de lumière infrarouge (130) et l'ajustement de l'intensité d'émission de la pluralité de diodes électroluminescentes infrarouges.
